# EUROPÄISCHE PATENTSCHRIFT

(11) **EP 2 499 506 B1**
(45) Veröffentlichungstag und Bekanntmachung des Hinweises auf die Patenterteilung: **16.08.2017**
(21) Anmeldenummer: 10775809.6
(22) Anmeldetag: 05.11.2010
(51) Int. Cl.: G01R 31/36, H01M 10/48, G01R 1/20, G01R 15/20

(54) **BATTERIE-STEUERGERÄT-ARCHITEKTUR**
ARCHITECTURE OF A BATTERY AND CONTROL DEVICE
ARCHITECTURE D'APPAREIL DE COMMANDE DE BATTERIE

(30) Priorität: 10.11.2009 DE 102009046564
(43) Veröffentlichungstag der Anmeldung: 19.09.2012
(73) Patentinhaber: Samsung SDI Co., Ltd., Gyeonggi-do (KR); Robert Bosch GmbH, 70442 Stuttgart (DE)
(72) Erfinder: TZIVANOPOULOS, Chrysanthos, 70806 Kornwestheim (DE); BUTZMANN, Stefan, 71717 Beilstein (DE)
(74) Vertreter: Bee, Joachim
(86) Internationale Anmeldenummer: PCT/EP2010/066908
(87) Internationale Veröffentlichungsnummer: WO 2011/057967

(56) Entgegenhaltungen:
- EP-A2- 1 289 096
- WO-A1-2009/106952
- DE-A1-102007 029 156
- US-A- 5 670 861
- US-A1- 2007 247 115

## Beschreibung

### Stand der Technik

Es besteht ein wachsender Bedarf an Batteriesystemen, welche in stationären Anwendungen wie Windkraftanlagen und Notstromsystemen oder aber in Fahrzeugen zum Einsatz kommen sollen. Alle diese Anforderungen stellen hohe Anforderungen an die Zuverlässigkeit und Ausfallsicherheit. Der Grund hierfür ist, dass ein vollständiger Ausfall der Spannungsversorgung durch das Batteriesystem zu einem Ausfall des Gesamtsystems führen kann. So werden bei Windkraftanlagen Batterien eingesetzt, um bei starkem Wind die Rotorblätter zu verstellen und die Anlage so vor übermäßigen mechanischen Belastungen zu schützen, die die Windkraftanlage beschädigen oder sogar zerstören können. Im Falle des Ausfalls der Batterie eines Elektroautos würde dieses fahruntüchtig. Ein Notstromsystem wiederum soll gerade den unterbrechungsfreien Betrieb z.B. eines Krankenhauses sicherstellen und daher selbst möglich nicht ausfallen können.

Um die für die jeweilige Anwendung geforderte Leistung und Energie zur Verfügung stellen zu können, werden einzelne Batteriezellen in einem Batteriemodul in Serie und teilweise zusätzlich parallel geschaltet, wobei eine hohe Gesamtspannung entsteht, welche eine Gefahrenquelle darstellt und abgesichert werden muss. So werden gewöhnlich zwei Hauptschütze vorgesehen, welche den positiven und den negativen Pol des Batteriemoduls auf ein entsprechendes Steuersignal hin abtrennen und das Batteriemodul so nach außen hin spannungsfrei schalten.

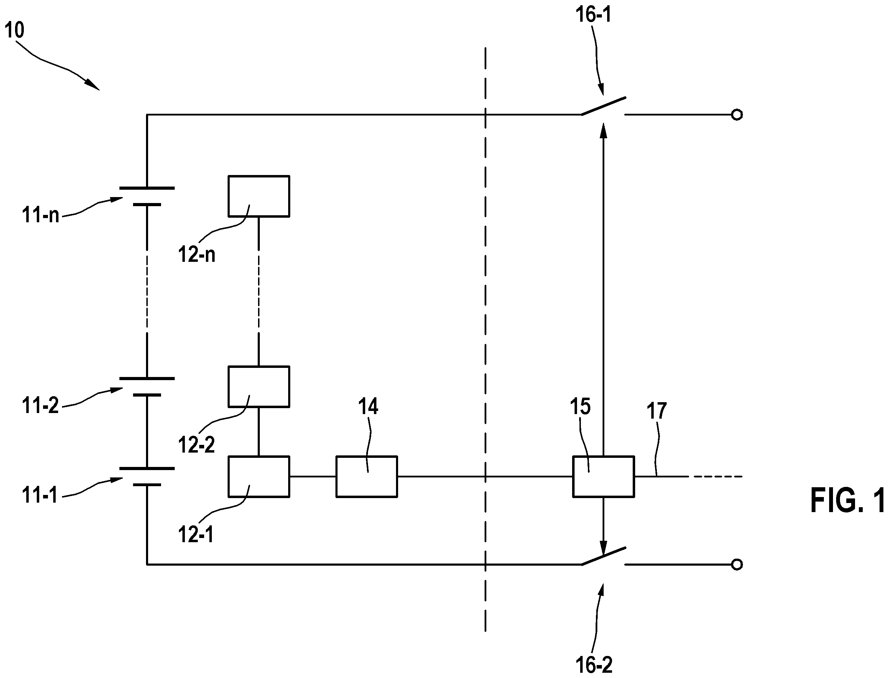

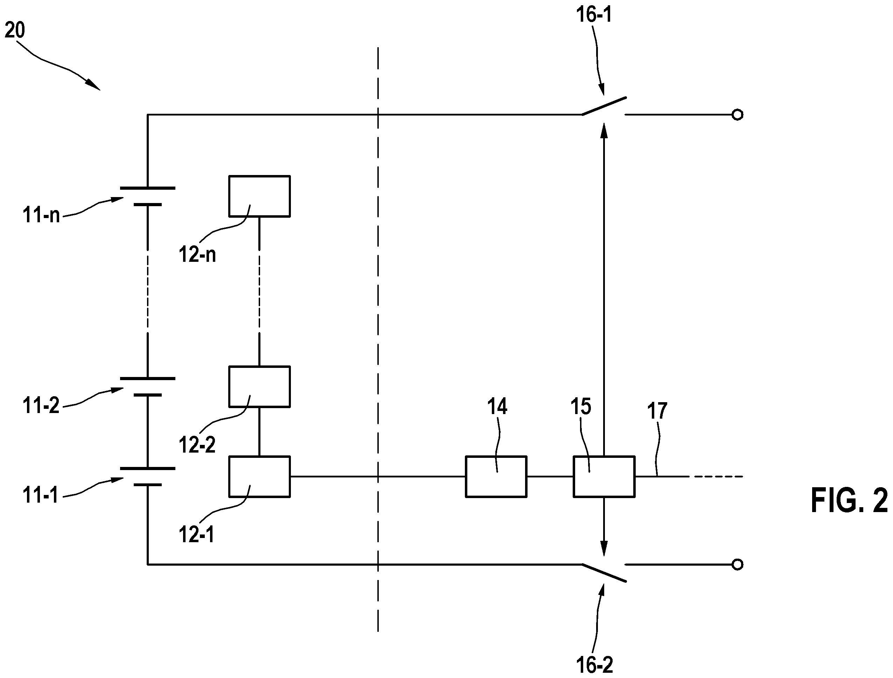

Zur Überwachung der Batteriezellen wird eine sog. Steuereinheit oder Battery Control Unit (BCU) eingesetzt, welche als zentrale Komponente einen Microcontroller aufweist. Die BCU wird in einem Niederspannungsnetz betrieben und muss somit von dem Hochspannungsnetz mit dem Batteriemodul isoliert werden. Gleichzeitig muss der Microcontroller der BCU aber aktuelle Messdaten von den Batteriezellen (bzw. im Batteriemodul angeordneten Zellüberwachungseinheiten, welche die diversen Batterieparameter messen) empfangen, um beispielsweise deren Ladungszustand oder Alterungszustand oder die Gesamtspannung des Batteriemoduls zu bestimmen, so dass eine Kommunikation zwischen Hochspannungsnetz und Niederspannungsnetz trotz des Isolationserfordernisses möglich sein muss. Da die Zellüberwachungseinheiten potentialmäßig an das Hochspannungsnetz angebunden sind, der Microcontroller der BCU aber an das Niederspannungsnetz, werden die Zellüberwachungseinheiten typischerweise über einen Isolationsbaustein oder Isolator an den Microcontroller angebunden. Fig. 1 und Fig. 2 zeigen Beispiele für eine solche Anordnung.

Im Beispiel der Fig. 1 ist ein Isolator 14 im Hochspannungsnetz angeordnet und mit einer Zellüberwachungseinheit 12-1 einer Vielzahl von Zellüberwachungseinheiten 12-1 bis 12-n verbunden. Die Zellüberwachungseinheiten 12-1 bis 12-n sind jeweils mit einer Batteriezelle oder einer Gruppe von Batteriezellen 11-1 bis 11-n verbunden. Ein Kommunikationsbus, an den alle Zellüberwachungseinheiten 12-1 bis 12-n angeschlossen sind, wird über den Isolator 14 und vom Hochspannungsnetz in das Niederspannungsnetz zum Microcontroller 15 geführt. Der Microcontroller 15 ist mit zwei Hauptschützen 16-1 und 16-2 verbunden, welche auf ein Steuersignal des Microcontrollers 15 hin die Batteriezellen 11-1 bis 11-n abtrennen oder mit einem Verbraucher verbinden. Der Microcontroller 15 ist mit weiteren Elektronikeinheiten über einen CAN-Bus 17 oder eine ähnliche Kommunikationsleitung verbunden. Alternativ kann der Isolator 14 auch im Niederspannungsnetz, beispielsweise auf der BCU, angeordnet sein, wie im Beispiel der Fig. 2 gezeigt, wobei gleiche Bezugszeichen gleiche Komponenten bezeichnen.

Die beiden in den Fig. 1 und 2 gezeigten Lösungen haben den Nachteil, dass der Isolator 14 hohe Kosten verursacht, weil er zumeist als SPI-Bus-Isolator realisiert werden muss.

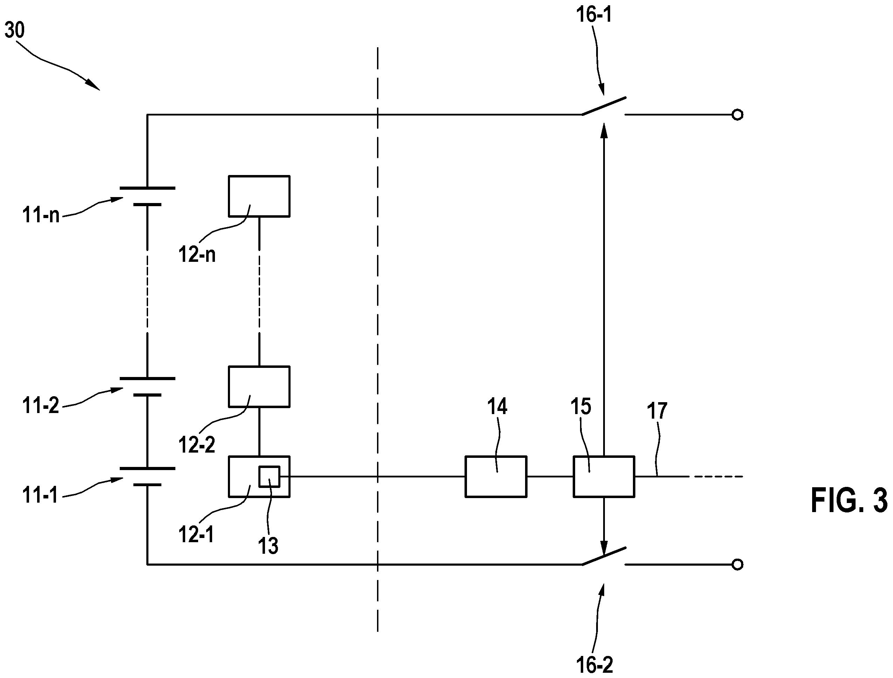

Fig. 3 zeigt eine weitere vorbekannte Lösung, bei der in eine Zellüberwachungseinheit 12-1 ein zusätzlicher Microcontroller 13 integriert wird, welcher über einen im Niederspannungsnetz angeordneten Isolator 14 mit dem Microcontroller 15 der BCU kommuniziert. Diese Lösung besitzt den Nachteil, dass eine der Zellüberwachungseinheiten anders gestaltet sein muss als die Zellüberwachungseinheiten für die verbleibenden Batteriezellen, behebt dafür das obengenannte Problem der hohen Kosten für den Isolator 14, da hier ein CAN-Bus zur Kommunikation über die Grenze zwischen Hochspannungsnetz und Niederspannungsnetz hinweg benutzt werden kann. Die Verwendung eines CAN-Busses bringt jedoch wiederum den Nachteil mit sich, dass die Synchronisierung der von den Zellüberwachungseinheiten im Hochspannungsnetz gemessenen Batteriespannungen mit der gewöhnlich im Niederspannungsnetz ausgeführten Messung des Batteriestroms aufgrund der Kommunikation über den CAN-Bus schwierig ist.

Zudem müssen in allen drei Beispielen vorbekannter Batteriesysteme komplexe Sicherheitsmechanismen vorgesehen werden, die sicherstellen, dass der Microcontroller 15 jederzeit korrekt funktioniert, da die verwendeten Li-Ionen-Batterien ein erhebliches Gefährdungspotential besitzen.

Aus der EP 1289096 A2 ist ein Batteriesystem mit einem ein Batteriemodul umfassenden Hochspannungsnetz und einem eine Batteriesteuereinheit umfassenden Niederspannungsnetz bekannt, wobei die Batteriesteuereinheit dazu ausgebildet ist, einen Ladungszustand der Batteriezellen zu bestimmen.

### Offenbarung der Erfindung

Die vorliegende Erfindung löst das Problem durch ein Batteriesystem entsprechend dem unabhängigen Anspruch 1. Erfindungsgemäße Ausgestaltungen werden durch die abhängigen Ansprüche offenbart.

Die obenstehenden Nachteile des Standes der Technik werden gelöst, durch ein Batteriesystem mit einem ein Batteriemodul umfassenden Hochspannungsnetz und einem eine BCU umfassenden Niederspannungsnetz, wobei das Batteriemodul eine Vielzahl von seriengeschalteten Batteriezellen und eine Mehrzahl von Zellüberwachungseinheiten aufweist. Die Zellüberwachungseinheiten sind ausgebildet, Batteriespannungen der Batteriezellen auf ein erstes Steuersignal hin zu messen und zu übermitteln. Die BCU ist dazu ausgebildet, einen Ladungszustand der Batteriezellen zu bestimmen. Erfindungsgemäß umfasst die BCU einen Microcontroller und einen Nanocontroller, wobei der Nanocontroller mit den Zellüberwachungseinheiten direkt verbunden oder verbindbar und mit dem Microcontroller über einen Isolator verbunden ist. Der Nanocontroller ist dabei ausgebildet, das erste Steuersignal zu erzeugen und an die Zellüberwachungseinheiten zu übermitteln und die von den Zellüberwachungseinheiten übermittelten Batteriespannungen der Batteriezellen zu empfangen und an den Microcontroller weiterzuübermitteln.

Die Zellüberwachungseinheiten kommunizieren erfindungsgemäß mit dem Nanocontroller. Das Batteriesystem der Erfindung besitzt dabei den Vorteil, dass für die Kommunikation zwischen Nanocontroller und Microcontroller ein Bus eingesetzt werden kann, der die Verwendung eines verhältnismäßig preiswerten Isolators erlaubt. Die Kommunikation zwischen Nanocontroller und Microcontroller ist nicht zeitkritisch, weil die von den Zellüberwachungseinheiten gemessenen Batteriespannungen bereits vom Nanocontroller vorverarbeitet werden können und der Zeitpunkt der Messungen durch diesen ohne Kommunikation über einen Isolator und somit ohne Zeitverzögerung genau bestimmt werden kann. Zudem können alle Zellüberwachungseinheiten identisch aufgebaut werden, was die Entwicklung und Produktion von speziellen Zellüberwachungseinheiten wie im Beispiel der Fig. 3 überflüssig und das Batteriesystem kostengünstiger macht. Als "Nanocontroller" wird hier ein Microcontroller bezeichnet, wobei der Begriff andeuten soll, dass ein Microcontroller mit verhältnismäßig geringerer Rechenleistung als die des in der BCU enthaltenen Microcontrollers verwendet werden kann, weil der Nanocontroller verhältnismäßig einfache Aufgaben übernimmt, welche geringe Anforderungen an die Rechenleistung stellen.

Es wird ein Batteriesystem bevorzugt, bei dem der Nanocontroller mit dem Microcontroller der BCU über den Isolator durch einen CAN-Bus verbunden ist.

Besonders bevorzugt ist der Nanocontroller mit einem ersten Stromsensor, vorzugsweise einem Shunt-Widerstand mit nachgeschalteter Auswerteeinheit, verbunden, welcher ausgebildet ist, einen Strom durch das Batteriemodul auf ein zweites Steuersignal hin zu messen und ein Strommessergebnis an den Nanocontroller zu übermitteln. In dieser Ausführungsform steuert der Nanocontroller neben der Messung der Batteriespannungen durch die Zellüberwachungseinheiten auch die Messung des Stroms durch das Batteriemodul. Dadurch wird es möglich, die beiden Messungen mit hoher Synchronizität auszuführen, was die Genauigkeit der Bestimmung von Ladezustand oder Alterungszustand der Batteriezellen erhöht. Daher wird eine Ausführungsform des erfindungsgemäßen Batteriesystems bevorzugt, bei dem der Nanocontroller ausgebildet ist, das erste und das zweite Steuersignal synchron zu erzeugen.

Der Nanocontroller kann zusätzlich ausgebildet sein, den Ladungszustand der Batteriezellen zu bestimmen. In diesem Fall führt der Nanocontroller eine der Aufgaben des Microcontrollers der BCU redundant aus, was die Ausfallsicherheit erhöht.

Der Nanocontroller kann außerdem ausgebildet sein, die Batteriespannungen mit einem vorgegebenen Grenzwert zu vergleichen und bei Überschreiten des vorgegebenen Grenzwert ein erstes Alarmsignal zu erzeugen. Auch hierbei handelt es sich um eine Aufgabe, die gewöhnlich vom Microcontroller der BCU übernommen wird, so dass die zusätzliche Überwachung der Batteriespannungen durch den Nanocontroller die Sicherheit im Falle eines Ausfalls des Microcontrollers der BCU erhöht.

Besonders bevorzugt sind Nanocontroller und Microcontroller ausgebildet, sich gegenseitig in regelmäßigen Abständen Überwachungsnachrichten zu senden und auf das Ausbleiben einer Antwort auf eine Überwachungsnachricht ein zweites Alarmsignal zu erzeugen. Erhält der Nanocontroller eine Überwachungsnachricht vom Microcontroller, antwortet er innerhalb eines vereinbarten Zeitraums mit einer Antwort. Entsprechend verfährt der Microcontroller mit vom Nanocontroller erhaltenen Überwachungsnachrichten. Bleibt nun eine Antwort aus, ist es wahrscheinlich, dass ein Verarbeitungsfehler auf der jeweils anderen Seite aufgetreten ist und diese ihre Überwachungsaufgaben nicht mehr oder nicht mehr zuverlässig wahrnehmen kann, weshalb derjenige Teil, der den Ausfall der anderen Seite feststellt, einen Alarm auslöst, woraufhin im Batteriesystem oder durch eine bedienende Person geeignete Maßnahmen eingeleitet werden können.

Der Microcontroller ist vorzugsweise mit einem zweiten Stromsensor, vorzugsweise einem Hall-Sensor, verbunden, welcher ausgebildet ist, einen Strom durch das Batteriemodul auf ein drittes Steuersignal hin zu messen und ein Strommessergebnis an den Microcontroller zu übermitteln. Auf diese Weise wird es möglich, den Strom durch das Batteriemodul zusätzlich zu der Bestimmung durch den Nanocontroller mittels des ersten Stromsensors direkt durch den Microcontroller zu bestimmen, wodurch diese unabhängiger vom Funktionieren des Nanocontrollers und der Batteriestrom redundant überwacht werden, wodurch die Sicherheit des Batteriesystems erhöht wird. Der zweite Stromsensor wird bevorzugt als Hall-Sensor ausgeführt, weil die einen Teil des Niederspannungsnetzes bildende BCU auf diese Weise galvanisch von den eine hohe Spannung führenden Teilen getrennt bleiben kann.

Das Batteriesystem kann ein zwischen einen ersten Pol der seriengeschalteten Batteriezellen und einen ersten Ausgang des Batteriemoduls geschaltetes erstes Hauptschütz und ein zwischen einen zweiten Pol der seriengeschalteten Batteriezellen und einen zweiten Ausgang des Batteriemoduls geschaltetes zweites Hauptschütz aufweisen. Bevorzugt besitzt dabei das erste Hauptschütz einen mit dem Nanocontroller verbundenen Steuereingang und das zweite Hauptschütz einen mit dem Microcontroller verbundenen Steuereingang. Nanocontroller und Microcontroller sind dabei ausgebildet, ein Öffnen und Schließen des ersten bzw. zweiten Hauptschützes zu steuern. In dieser Ausführungsform kontrollieren Nanocontroller und Microcontroller jeweils eines der Hauptschütze. Für den Fall, dass eine der Verarbeitungseinheiten (Nanocontroller oder Microcontroller) ausfällt und dadurch eines der beiden Hauptschütze nicht geöffnet wird, wird die jeweils andere Verarbeitungseinheit dies bemerken und eine geeignete Reaktion auslösen. Zu diesem Zweck sind bei einer besonderen Ausführungsform der Erfindung der Nanocontroller zusätzlich mit dem Steuereingang des zweiten Hauptschützes und der Microcontroller zusätzlich mit dem Steuereingang des ersten Hauptschützes verbunden, wobei Nanocontroller und Microcontroller ausgebildet sind, den zweiten Hauptschütz bzw. den ersten Hauptschütz (also den jeweils anderen Hauptschütz) zu öffnen, wenn der Microcontroller bzw. der Nanocontroller ausfallen. Die Feststellung, dass die jeweils andere Verarbeitungseinheit ausgefallen ist, kann spätestens getroffen werden, wenn die Zellspannungen und der Batteriestrom nicht mehr in unkritischen Bereichen liegen. Außerdem ist eine Kombination mit dem vorgenannten Ausführungsbeispiel besonders attraktiv, in dem sich Nanocontroller und Microcontroller gegenseitig durch Überwachungsnachrichten und Antworten überwachen.

### Kurzbeschreibung der Abbildung

Die Erfindung wird im folgenden anhand einer Abbildungen eines Ausführungsbeispiels näher erläutert. Es zeigt:

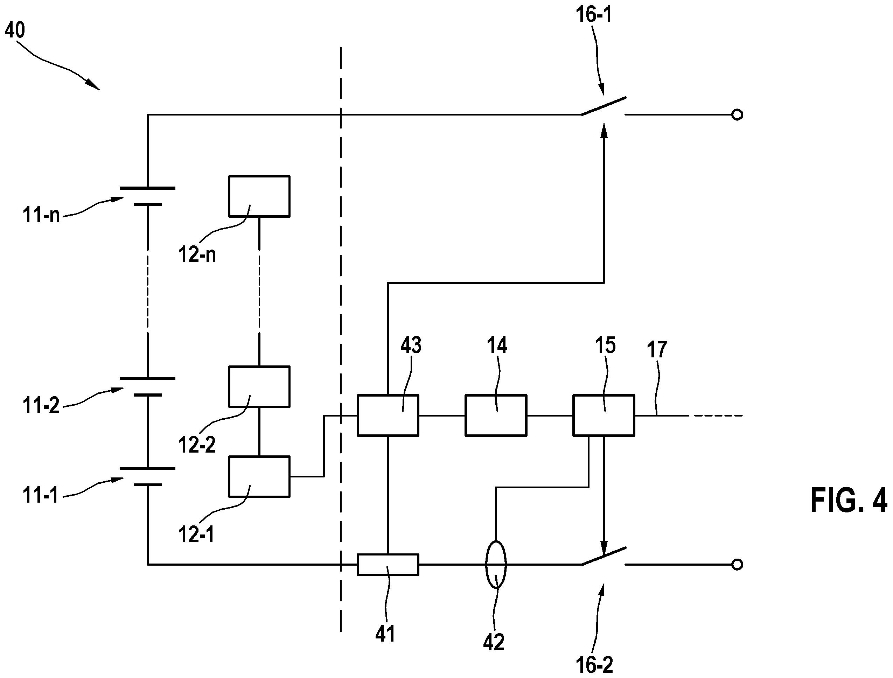

Fig. 4 ein Ausführungsbeispiel der Erfindung.

### Ausführliche Beschreibung der Abbildung

Fig. 4 zeigt ein Ausführungsbeispiel der Erfindung. Gleiche Bezugszeichen wie in den vorherigen Abbildungen bezeichnen gleiche Elemente. Das Batteriesystem 40 der Fig. 4 verfügt über ein Hochspannungsnetz, welches ein Batteriemodul mit einer Vielzahl von in Serie geschalteten Batteriezellen 11-1 bis 11-n und den Batteriezellen zugeordnete Zellüberwachungseinheiten 12-1 bis 12-n umfasst. Die Zellüberwachungseinheiten 12-1 bis 12-n sind ausgebildet, Batteriespannungen der Batteriezellen 11-1 bis 11-n zu bestimmen. Außerdem können die Zellüberwachungseinheiten 12-1 bis 12-n ausgebildet sein, weitere Batterieparameter wie z.B. die Zelltemperatur zu bestimmen. Die Zellüberwachungseinheiten 12-1 bis 12-n kommunizieren über einen Bus mit einem Nanocontroller 43, welcher im Niederspannungsnetz des Batteriesystems 40 angeordnet ist. Der Nanocontroller 43 veranlasst Messungen durch die Zellüberwachungseinheiten 12-1 bis 12-n und empfängt von diesen die Messergebnisse. Um dem Erfordernis einer hinreichenden Absicherung des Hochspannungsnetzes zu genügen, kommuniziert der Nanocontroller 43 mit einem Microcontroller 15 über einen Isolator 14. Vorzugsweise wird die Kommunikation dabei über einen CAN-Bus abgewickelt, welcher den Einsatz eines besonders preisgünstigen Isolators 14 erlaubt. Im abgebildeten Beispiel besitzt der Nanocontroller 43 einen Steuerausgang zu einem der beiden Hauptschütze 16-1 und 16-2, während der andere Hauptschütz 16-1, 16-2 an den Microcontroller 15 angebunden ist. Somit obliegt jeder der beiden Verarbeitungseinheiten die Steuerung jeweils eines der Hauptschütze 16-1, 16-2. Der Nanocontroller 43 ist mit einem als Shunt-Widerstand mit nachgeschalteter Auswertungselektronik ausgeführten ersten Stromsensor 41 verbunden und kann so mittels des Shunt-Widerstandes den Strom durch das Batteriemodul bzw. die Batteriezellen 11-1 bis 11-n synchron zur Messung der Batteriespannungen der Batteriezellen 11-1 bis 11-n bestimmen. Zusätzlich dazu ist ein als Hall-Sensor ausgeführter zweiter Stromsensor 42 vorgesehen, welcher mit dem Microcontroller 15 verbunden ist und von dieser gesteuert wird, was die redundante Bestimmung des Batteriestroms erlaubt und beispielsweise eine höhere Sicherheit zum Schutz gegen Kurzschlüsse des Batteriemoduls bietet. Der Microcontroller 15 kann über einen CAN-Bus 17 oder einen ähnlichen Kommunikationsbus mit weiteren Komponenten verbunden sein. Je nach Ausführungsform können der Nanocontroller 43 und der Microcontroller 15 die Hauptschütze 16-1, 16-2 über sog. Power Driver ansteuern, welche genügend Leistung für die Ansteuerung der beispielsweise als Relais ausgeführten Hauptschütze 16-1, 16-2 zur Verfügung stellen. Das Batteriesystem kann auch über so genannte Watchdogs für den Microcontroller 15 und/oder den Nanocontroller 43 verfügen, welche in bekannter Weise deren korrekte Funktionsweise sicherstellen.

## Patentansprüche

1. Ein Batteriesystem (40) mit einem ein Batteriemodul umfassenden Hochspannungsnetz und einem eine Batterie-Steuereinheit (BCU) umfassenden Niederspannungsnetz, wobei das Batteriemodul eine Vielzahl von seriengeschalteten Batteriezellen (11-1,..., 11-n) und eine Mehrzahl von Zellüberwachungseinheiten (12-1,..., 12-n) aufweist, welche ausgebildet sind, Batteriespannungen der Batteriezellen (11-1,..., 11-n) auf ein erstes Steuersignal hin zu messen und zu übermitteln, und wobei die BCU (15) dazu ausgebildet ist, einen Ladungszustand der Batteriezellen (11-1,..., 11-n) zu bestimmen, wobei die BCU einen Mikrocontroller (15) und einen Nanocontroller (43) umfasst, wobei der Nanocontroller (43) mit den Zellüberwachungseinheiten (12-1,..., 12-n) direkt verbunden oder verbindbar und mit dem Mikrocontroller (15) über einen Isolator (14) verbunden und ausgebildet ist, das erste Steuersignal zu erzeugen und an die Zellüberwachungseinheiten (12-1,..., 12-n) zu übermitteln und die von den Zellüberwachungseinheiten (12-1,..., 12-n) übermittelten Batteriespannungen der Batteriezellen (11-1,..., 11-n) zu empfangen und an den Mikrocontroller (15) weiter zu übermitteln, **dadurch gekennzeichnet, dass** der Nanocontroller (43) mit einem ersten Stromsensor (41), vorzugsweise einem Shunt-Widerstand mit nachgeschalteter Auswerteeinheit, verbunden ist, welcher ausgebildet ist, einen Strom durch das Batteriemodul auf ein zweites Steuersignal hin zu messen und ein Strommessergebnis an den Nanocontroller (43) zu übermitteln.

2. Das Batteriesystem (40) von Anspruch 1, bei dem der Nanocontroller (43) mit dem Mikrocontroller (15) über den Isolator (14) durch einen CAN-Bus verbunden ist.

3. Das Batteriesystem (40) von Anspruch 2, bei dem der Nanocontroller (43) ausgebildet ist, das erste und das zweite Steuersignal synchron zu erzeugen.

4. Das Batteriesystem (40) von einem der vorhergehenden Ansprüche, bei dem der Nanocontroller (43) ausgebildet ist, den Ladungszustand der Batteriezellen (11-1,..., 11-n) zu bestimmen.

5. Das Batteriesystem (40) von einem der vorhergehenden Ansprüche, bei dem der Nanocontroller (43) ausgebildet ist, die Batteriespannungen mit einem vorgegebenen Grenzwert zu vergleichen und bei Überschreiten des vorgegebenen Grenzwert ein erstes Alarmsignal zu erzeugen.

6. Das Batteriesystem (40) von einem der vorhergehenden Ansprüche, bei dem der Nanocontroller (43) und der Mikrocontroller (15) ausgebildet sind, sich gegenseitig in regelmäßigen Abständen Überwachungsnachrichten zu senden und auf das Ausbleiben einer Antwort auf eine Überwachungsnachricht ein zweites Alarmsignal zu erzeugen.

7. Das Batteriesystem (40) von einem der vorhergehenden Ansprüche, bei dem der Mikrocontroller (15) mit einem zweiten Stromsensor (42), vorzugsweise einem Hall-Sensor, verbunden ist, welcher ausgebildet ist, einen Strom durch das Batteriemodul auf ein drittes Steuersignal hin zu messen und ein Strommessergebnis an den Mikrocontroller (15) zu übermitteln.

8. Das Batteriesystem (40) von Anspruch 7, mit einem zwischen einen ersten Pol der seriengeschalteten Batteriezellen (11-1,..., 11-n) und einen ersten Ausgang des Batteriemoduls geschalteten ersten Hauptschütz (16-1) und einem zwischen einen zweiten Pol der seriengeschalteten Batteriezellen (11-1,..., 11-n) und einen zweiten Ausgang des Batteriemoduls geschalteten zweiten Hauptschütz (16-2), wobei das erste Hauptschütz (16-1) einen mit dem Nanocontroller (43) verbundenen Steuereingang und das zweite Hauptschütz (16-2) einen mit dem Mikrocontroller (15) verbundenen Steuereingang aufweisen und Nanocontroller (43) und Mikrocontroller (15) ausgebildet sind, ein Öffnen und Schließen des ersten bzw. zweiten Hauptschützes (16-1, 16-2) zu steuern.

9. Das Batteriesystem (40) von Anspruch 8, bei dem der Nanocontroller (43) zusätzlich mit dem Steuereingang des zweiten Hauptschützes (16-2) und der Mikrocontroller (15) zusätzlich mit dem Steuereingang des ersten Hauptschützes (16-1) verbunden sind, wobei Nanocontroller (43) und Mikrocontroller (15) ausgebildet sind, den zweiten Hauptschütz (16-2) bzw. den ersten Hauptschütz (16-1) zu öffnen, wenn der Mikrocontroller (15) bzw. der Nanocontroller (43) ausfallen.

## Claims

1. Battery system (40) having a high voltage network comprising a battery module and a low voltage network comprising a battery control unit (BCU), wherein the battery module has a plurality of battery cells (11-1, ..., 11-n) connected in series and a plurality of cell monitoring units (12-1, ..., 12-n) which are designed to measure battery voltages of the battery cells (11-1, ..., 11-n) in response to a first control signal and to transmit said battery voltages, and wherein the BCU (15) is designed to determine a state of charge of the battery cells (11-1, ..., 11-n), wherein the BCU comprises a microcontroller (15) and a nanocontroller (43), wherein the nanocontroller (43) is connected or can be connected directly to the cell monitoring units (12-1,..., 12-n) and is connected to the microcontroller (15) via an isolator (14), and is designed to generate the first control signal and to transmit it to the cell monitoring units (12-1, ..., 12-n) and to receive the battery voltages of the battery cells (11-1, ..., 11-n) which are transmitted by the cell monitoring units (12-1, ..., 12-n), and to relay said battery voltages to the microcontroller (15), **characterized in that** the nanocontroller (43) is connected to a first current sensor (41), preferably a shunt resistor with an evaluation unit connected downstream, which shunt resistor is designed to measure a current through the battery module in response to a second control signal, and to transmit a current measurement result to the nanocontroller (43).

2. Battery system (40) according to Claim 1, in which the nanocontroller (43) is connected to the microcontroller (15) via the isolator (14) by means of a CAN bus.

3. Battery system (40) according to Claim 2, in which the nanocontroller (43) is designed to generate the first and the second control signals synchronously.

4. Battery system (40) according to one of the preceding claims, in which the nanocontroller (43) is designed to determine the state of charge of the battery cells (11-1 ..., 11-n).

5. Battery system (40) according to one of the preceding claims, in which the nanocontroller (43) is designed to compare the battery voltages with a predefined limiting value, and to generate a first alarm signal when the predefined limiting value is exceeded.

6. Battery system (40) according to one of the preceding claims, in which the nanocontroller (43) and the microcontroller (15) are designed to transmit monitoring messages to one another at regular intervals and to generate a second alarm signal if a response to a monitoring message fails to occur.

7. Battery system (40) according to one of the preceding claims, in which the microcontroller (15) is connected to a second current sensor (42), preferably a Hall sensor, which is designed to measure a current through the battery module in response to a third control signal, and to transmit a current measurement result to the microcontroller (15).

8. Battery system (40) according to Claim 7, having a first main contactor (16-1), connected between a first pole of the battery cells (11-1 ,..., 11-n) connected in series and a first output of the battery module, and a second main contactor (16.2), connected between a second pole of the battery cells (11-1 ,..., 11-n) connected in series and a second output of the battery module, wherein the first main contactor (16-1) has a control input connected to the nanocontroller (43), and the second main contactor (16-2) has a control input connected to the microcontroller (15), and the nanocontroller (43) and the microcontroller (15) are designed to control opening and closing of the first and/or second main contactor (16-1, 16-2).

9. Battery system (40) according to Claim 8, in which the nanocontroller (43) is additionally connected to the control input of the second main contactor (16-2), and the microcontroller (15) is additionally connected to the control input of the first main contactor (16-1), wherein the nanocontroller (43) and the microcontroller (15) are designed to open the second main contactor (16-2) and/or the first main contactor (16-1) if the microcontroller (15) and/or the nanocontroller (43) fail.

## Revendications

1. Système de batterie (40) avec un réseau à haute tension comprenant un module de batterie et avec un réseau à basse tension comprenant une unité de commande de batterie (BCU), selon lequel le module de batterie présente une pluralité de cellules de batterie (11-1, ..., 11-n) montées en série, ainsi qu'une pluralité d'unités de surveillance des cellules de batterie (12-1, ..., 12-n), lesquelles sont conçues en vue de mesurer et de transmettre des tensions de batterie des cellules de batterie (11-1, ..., 11-n) sur un premier signal de commande, et selon lequel la BCU (15) est conçue en vue de déterminer un état de charge des cellules de batterie (11-1, ..., 11-n), selon lequel la BCU comprend un microcontrôleur (15) et un nanocontrôleur (43), selon lequel le nanocontrôleur (43) est directement raccordé ou peut être directement raccordé aux unités de surveillance des cellules de batterie (12-1, ..., 12-n) et est raccordé au microcontrôleur (15) par l'intermédiaire d'un isolateur (14) et est conçu en vue de produire le premier signal de commande et de le transmettre aux unités de surveillance des cellules de batterie (12-1, ..., 12-n) et en vue de recevoir les tensions de batterie des cellules de batterie (11-1, ..., 11-n) transmises par les unités de surveillance des cellules de batterie (12-1, ..., 12-n) et de les retransmettre au microcontrôleur (15),
**caractérisé en ce que**
le nanocontrôleur (43) est raccordé à un premier capteur de courant (41), de préférence à une résistance de shunt comprenant une unité de traitement montée en aval, laquelle est conçue en vue de mesurer un courant traversant le module de batterie sur un deuxième signal de commande et de transmettre un résultat de mesure du courant au nanocontrôleur (43).

2. Système de batterie (40) selon la revendication 1, pour lequel le nanocontrôleur (43) est raccordé au microcontrôleur (15) par l'intermédiaire de l'isolateur (14) au moyen d'un bus de données CAN.

3. Système de batterie (40) selon la revendication 2, pour lequel le nanocontrôleur (43) est conçu en vue de produire, de manière synchrone, le premier signal de commande et le deuxième signal de commande.

4. Système de batterie (40) conformément à l'une des revendications précédentes, pour lequel le nanocontrôleur (43) est conçu en vue de déterminer l'état de charge des cellules de batterie (11-1, ..., 11-n).

5. Système de batterie (40) conformément à l'une des revendications précédentes, pour lequel le nanocontrôleur (43) est conçu en vue de comparer les tensions de batterie avec une valeur limite prédéfinie et en vue de produire un premier signal d'alerte quand la valeur limite prédéfinie est dépassée.

6. Système de batterie (40) conformément à l'une des revendications précédentes, pour lequel le nanocontrôleur (43) et le microcontrôleur (15) sont conçus en vue de se transmettre mutuellement des messages de surveillance à intervalles irréguliers et en vue de produire un deuxième signal d'alerte en l'absence d'une réponse à un message de surveillance.

7. Système de batterie (40) conformément à l'une des revendications précédentes, pour lequel le microcontrôleur (15) est raccordé à un deuxième capteur de courant (42), de préférence à un capteur à effet Hall, lequel est conçu en vue de mesurer un courant traversant le module de batterie sur un troisième signal de commande et en vue de transmettre un résultat de mesure du courant au microcontrôleur (15).

8. Système de batterie (40) selon la revendication 7, avec un premier contacteur principal (16-1) qui est mis en circuit entre un premier pôle des cellules de batterie (11-1, ..., 11-n) montées en série et une première sortie du module de batterie, ainsi qu'avec un deuxième contacteur principal (16-2) qui est mis en circuit entre un deuxième pôle des cellules de batterie (11-1, ..., 11-n) montées en série et une deuxième sortie du module de batterie, selon lequel le premier contacteur principal (16-1) présente une entrée de commande raccordée au nanocontrôleur (43) et le deuxième contacteur principal (16-2) présente une entrée de commande raccordée au microcontrôleur (15) et selon lequel le nanocontrôleur (43) et le microcontrôleur (15) sont conçus en vue de commander une ouverture et une fermeture du premier, respectivement du deuxième contacteur principal (16-1, 16-2).

9. Système de batterie (40) selon la revendication 8, pour lequel le nanocontrôleur (43) est en outre raccordé à l'entrée de commande du deuxième contacteur principal (16-2) et le microcontrôleur (15) est en outre raccordé à l'entrée de commande du premier contacteur principal (16-1), selon lequel le nanocontrôleur (43) et le microcontrôleur (15) sont conçus en vue d'ouvrir le deuxième contacteur principal (16-2), respectivement le premier contacteur principal (16-1) en cas de défaillance du microcontrôleur (15), respectivement du nanocontrôleur (43).
